# EUROPÄISCHE PATENTANMELDUNG

(11) **EP 1 191 537 A1**
(43) Veröffentlichungstag der Anmeldung: **27.03.2002**
(21) Anmeldenummer: 01121931.8
(22) Anmeldetag: 12.09.2001
(51) Int. Cl.: G11C 7/10, G11C 8/12

(54) **Integrierter Speicher und Speicheranordnung mit mehreren Speichern sowie Verfahren zum Betrieb einer solchen Speicheranordnung**

(30) Priorität: 20.09.2000 DE 10046578
(71) Anmelder: Infineon Technologies AG, 81669 München (DE)
(72) Erfinder: Pöchmüller, Peter, Dr., Colchester, VT 05446 (US)
(74) Vertreter: Epping Hermann & Fischer

(57) **Zusammenfassung**

Eine Speicheranordnung weist wenigstens zwei miteinander verbundene Speicher (11) auf. Bei einem Speicherzellezugriff wird in einer Vergleichsschaltung (6) des ersten Speichers (11) festgestellt wird, ob die an eine erste Kommunikationsschnittstelle (4) des Speichers angelegte Adresse (ADR) mit einer Adresse (RADR) von im ersten Speicher gespeicherten Daten übereinstimmt. Bei Nicht-Übereinstimmung der Adressen wird die Adresse (ADR) der angeforderten Daten von einer Kontrollschaltung (7) über eine von der ersten Kommunikationsschnittstelle unabhängig betreibbare zweite Kommunikationsschnittstelle (5) zum zweiten gleichartigen Speicher (12) transferiert. Die angeforderten Daten (DA) werden vom zweiten Speicher (12) über die zweite Kommunikationsschnittstelle (5) des ersten Speichers (11) empfangen und über die erste Kommunikationsschnittstelle (4) des ersten Speichers (11) ausgegeben. Durch Punkt-zu-Punkt-Verbindungen ist eine hohe Datenübertragungsrate der Speicheranordnung (3) und damit ein hoher Datendurchsatz bei weiterhin guter Signalqualität ermöglicht.

## Beschreibung

Integrierter Speicher und Speicheranordnung mit mehreren Speichern sowie Verfahren zum Betrieb einer solchen Speicheranordnung

Die vorliegende Erfindung betrifft einen integrierten Speicher und eine Speicheranordnung mit wenigstens einem ersten Speicher und zweitem Speicher sowie ein Verfahrens zum Betrieb einer Speicheranordnung mit wenigstens einem ersten Speicher und einem zweiten Speicher.

Anordnungen wie beispielsweise Personal Computer Systeme (PC-Systeme) weisen im allgemeinen Datenverarbeitungseinrichtungen in Form von Mikroprozessoren oder Mikrocontrollern und Funktionseinheiten wie Programmspeicher, Datenspeicher oder Ein-/Ausgabeperipherie-Baugruppen auf. Der Mikroprozessor stellt dabei meist die zentrale Steuer- und Recheneinheit dar und wird deshalb auch als sogenannte Central Processing Unit (CPU) bezeichnet. Der Datenspeicher, der im allgemeinen als sogenanntes Random Access Memory (RAM) ausgeführt ist, enthält beispielsweise Daten, auf die während eines Speicherzugriffs zugegriffen wird. Die elektrische Verbindung zwischen dem Mikroprozessor und beispielsweise dem Datenspeicher wird üblicherweise über ein Bussystem hergestellt.

Es ist im allgemeinen zu beobachten, daß Mikroprozessoren zur Steigerung des Datendurchsatzes mit steigenden Verarbeitungsgeschwindigkeiten und damit auch steigenden Übertragungsfrequenzen betrieben werden. Insbesondere aus diesem Grund ist man bestrebt, die Verarbeitungsgeschwindigkeit beziehungsweise Übertragungsfrequenz auf den entsprechenden Bussystemen ebenfalls zu erhöhen, um die Gesamtleistung des PC-Systems nicht einzuschränken. Dies kann im allgemeinen jedoch zu physikalischen und/oder elektrischen Problemen führen. Insbesondere bei verhältnismäßig langen Bussystemen, die mit einer Speicheranordnung mit mehreren parallel angeschlossenen Speichern oder Speichermodulen verbunden sind, können mit zunehmenden Übertragungsfrequenzen starke Reflexionen und Störungen von zu übertragenden Signalen entstehen. Diese können die Signalqualität und damit die Detektierbarkeit der zu übertragenden Daten beeinträchtigen. Diese Reflexionen und Störungen sind beispielsweise bedingt durch eine Vielzahl von parallel angeschlossenen Speichermodulen und die damit eingeschränkten Möglichkeiten zur geeigneten Anpassung der elektrischen Parameter und/oder durch begrenzte elektrische Eigenschaften der Bussysteme und der angeschlossenen Speichermodule.

Die Aufgabe der vorliegenden Erfindung ist es, einen integrierten Speicher und eine Speicheranordnung mit wenigstens einem ersten Speicher und zweiten Speicher anzugeben, durch die jeweils ein vergleichsweise hoher Datendurchsatz bei weiterhin guter Detektierbarkeit der zu übertragenden Daten ermöglicht ist.

Weiterhin ist es Aufgabe der vorliegenden Erfindung, ein Verfahren zum Betrieb einer Speicheranordnung mit wenigstens einem ersten Speicher und zweiten Speicher anzugeben, durch das ein vergleichsweise hoher Datendurchsatz der Speicheranordnung beispielsweise zu einem Mikrocontroller bei weiterhin guter Detektierbarkeit der zu übertragenen Daten erzielbar ist.

Die Aufgabe betreffend den integrierten Speicher wird gelöst durch einen integrierten Speicher gemäß Patentanspruch 1.

Die Aufgabe betreffend die Speicheranordnung wird gelöst durch eine Speicheranordnung gemäß Patentanspruch 10.

Die Aufgabe betreffend das Verfahren zum Betrieb einer Speicheranordnung wird gelöst durch ein Verfahren zum Betrieb einer Speicheranordnung gemäß Patentanspruch 16.

Mit dem erfindungsgemäßen Speicher und der erfindungsgemäßen Speicheranordnung ist es möglich, einen vergleichsweise hohen Datendurchsatz von zu übertragenden Daten zu erzielen. Dies wird insbesondere dadurch erreicht, daß der an den ersten Speicher angeschlossene Kommunikationsbus und die Verbindung zwischen den erstem Speicher und dem zweiten Speicher elektrisch entkoppelt sind. Dadurch ist es möglich, daß der Kommunikationsbus und das Bussystem zwischen dem ersten Speicher und dem zweiten Speicher mit vergleichsweise hohen Datenübertragungsfrequenzen betrieben werden können.

Durch die elektrische Trennung der Bussysteme ist es weiterhin möglich, die Bussysteme derart auszuführen, daß relativ geringe Signalreflexionen auftreten. Damit kann die Signalqualität und damit auch die Übertragungsfrequenz deutlich erhöht werden. Durch die erfindungsgemäße Speicheranordnung werden sogenannte Punkt-zu-Punkt-Verbindungen der Bussysteme geschaffen, die so gestaltet werden können, daß relativ geringe Reflexionen auch bei relativ hohen Signalfrequenzen auftreten. Hierdurch können die Signalqualität und somit die Signalfrequenz erhöht werden. Durch die Schaffung von getrennten Bussystemen ist es außerdem nicht unbedingt erforderlich, die elektrischen Anforderungen an das die beiden Speicher verbindende Bussystem sowie die elektrischen Anforderungen an den zweiten Speicher selbst beziehungsweise dessen Schnittstelleneinheit zu erhöhen.

Durch die Erfindung ist es insbesondere ermöglicht, im Prinzip beliebig große Speichersysteme zu realisieren, ohne die Datenübertragungsfrequenz reduzieren zu müssen. Die erfindungsgemäße Speicheranordnung kann prinzipiell um beliebig viele Speicher beziehungsweise Speicherbausteine erweitert werden. Dies stellt vor allem einen großen Vorteil für zukünftige Server-Realisierungen beispielsweise für das Internet dar.

Die Erfindung ist vorteilhaft anwendbar in einem Hauptspeichersystem eines PC-Systems. Dieses umfaßt üblicherweise ein relativ langes Speicherbussystem, an das ein oder mehrere Speichermodule, die im allgemeinen als sogenannte RAMs ausgeführt sind, angeschlossen sind.

Der erfindungsgemäße Speicher beziehungsweise die erfindungsgemäße Speicheranordnung unterstützt durch die Funktion der Vergleichsschaltung in Verbindung mit der Kontrollschaltung einen sogenannten Cache-Mechanismus. Das bedeutet insbesondere, im Falle daß die Speicheranordnung mit beispielsweise einem Mikrocontroller verbunden ist, daß die vom Mikrocontroller aktuell benötigte Information möglichst im ersten Speicher gespeichert ist, wohingegen seit längerer Zeit nicht mehr benötigte Information möglichst im zweiten Speicher gespeichert wird und damit weiter vom Mikrocontroller entfernt wird. Im Falle, daß im zweiten Speicher gespeicherte Information vom Mikrocontroller benötigt wird, wird diese automatisch, gesteuert durch die Kontrollschaltung, über die zweite Kommunikationsschnittstelle des ersten Speichers angefordert und empfangen und über die erste Kommunikationsschnittstelle des ersten Speichers zum Mikrocontroller ausgegeben.

Setzt man dabei voraus, daß ein Mikroprozessor beziehungsweise die Anwendung, die in dem Mikroprozessor abläuft, in einem längeren Zeitabschnitt auf nahezu die gleiche Information zugreift, wird die Zugriffszeit einzelner Speicherzugriffe insgesamt weiter erniedrigt, wenn diese Information im ersten Speicher gespeichert ist. Die Punkt-zu-Punkt-Verbindung zwischen dem Mikroprozessor und dem ersten Speicher kann entsprechend hochfrequent betrieben werden. Zum Zwecke einer moderaten Kostenerhöhung kann die Verbindung zwischen dem ersten Speicher und zweiten Speicher entsprechend mit niedrigerer Frequenz betrieben werden.

Zur Unterstützung eines derartigen Cache-Mechanismus ist es deshalb zweckmäßig, die über die zweite Kommunikationsschnittstelle empfangenen Daten im ersten Speicher zu speichern. Dadurch können zukünftige Speicherzugriffe in der Nähe des letzten Speicherzugriffs schneller bearbeitet werden, da die zuletzt benötigte Information in die Nähe des Mikroprozessors bewegt wurde. Es sind dabei jedoch auch Realisierungen denkbar, in denen direkt ein Transfer von benötigten Daten zum ersten Speicher erfolgt, ohne daß diese Daten zunächst im ersten Speicher gespeichert werden.

In einer weiteren vorteilhaften Weiterbildung des Verfahrens werden die empfangenen Daten erst nach Ausgabe über die erste Kommunikationsschnittstelle im ersten Speicher gespeichert. Dadurch kann ein an den ersten Speicher angeschlossener Mikrocontroller nach einem Speicherzugriff sofort weiter arbeiten. Nach dem Speicherzugriff kann parallel zu anderen Mikrokontrollerzugriffen die zuletzt benötigte Information in den ersten Speicher transferiert werden und dort gespeichert werden.

In einer besonders vorteilhaften Ausführungsform des erfindungsgemäßen Verfahrens wird im ersten Speicher ein frei verfügbarer Speicherbereich zur Speicherung von Daten definiert, der zur Speicherung von über die zweite Kommunikationsschnittstelle empfangenen Daten verwendet wird. Die Speicheranordnung wird dabei bevorzugt derart betrieben, daß mindestens ein Speicherbereich des ersten Speichers "leer" ist, das heißt vor der Speicherung von empfangenen Daten keine relevanten beziehungsweise anforderbaren Daten in dem entsprechenden Speicherbereich gespeichert sind, auf die zugegriffen werden könnte.

Wird ein frei verfügbarer Speicherbereich des ersten Speichers mit vom zweiten Speicher empfangenen Daten beschrieben, ist kein frei verfügbarer Speicherbereich mehr vorhanden. Aus diesem Grund ist es vorteilhaft, den ersten Speicher in mehrere Speicherbereiche etwa in Form von Speicherbänken zur Speicherung von Daten zu unterteilen, Daten eines der Speicherbereiche in den zweiten Speicher zu transferieren und diesen Speicherbereich als frei verfügbaren Speicherbereich zu definieren. Bevorzugt wählt man dabei Daten eines Speicherbereichs, auf die bereits seit längerer Zeit kein Speicherzugriff mehr erfolgt ist. Die Daten eines derartigen Speicherbereichs werden beispielsweise dann transferiert, wenn kein frei verfügbarer Speicherbereich im ersten Speicher mehr vorhanden ist.

Die Erfindung ist weiterhin vorteilhaft für Reparatur fehlerhafter Speicherbereiche des ersten Speichers und/oder des zweiten Speichers nutzbar. Dazu ist der erste Speicher und/oder der zweite Speicher in mehrere Speicherbereiche zur Speicherung von Daten unterteilt, wobei einer der Speicherbereiche des ersten Speichers und/oder des zweiten Speichers beispielsweise im Falle fehlerhafter Speicherzellen für einen Datenzugriff gesperrt wird. Die Speicheranordnung kann dadurch zuverlässig weiterverwendet werden.

Die Sperrung kann beispielsweise direkt in der Produktion erfolgen. Der betreffende Speicher weist dazu beispielsweise programmierbare Elemente zur Speicherung einer Adresse eines zu deaktivierenden Speicherbereichs auf. Die programmierbaren Elemente sind vorteilhaft in Form von elektrischen oder metallischen Sicherungen ausgeführt. Diese sind beispielsweise mittels einer elektrischen Spannung beziehungsweise eines Laserstrahls durchtrennbar beziehungsweise programmierbar. Eine Sperrung eines Speicherbereichs kann auch während eines Betriebs der Speicheranordnung durchgeführt werden. Wird während des Betriebs beispielsweise der Ausfall von einzelnen Speicherzellen festgestellt, kann bei Auftreten solcher Fehlerereignisse der betroffene Speicherbereich für den weiteren Betrieb gesperrt werden. Dies kann zum Beispiel durch Setzen eines entsprechenden Registers oder durch Programmieren von elektrisch programmierbaren Elementen erfolgen.

In einer vorteilhaften Ausführungsform des erfindungsgemäßen integrierten Speichers ist das Speicherzellenfeld des Speichers in zwei Speicherblöcke aufgeteilt, die unabhängig voneinander mit dem Datenbussystem verbindbar sind. Dadurch ist eine effiziente Realisierung des Cache-Konzepts ermöglicht. Zur weiteren Effizienzsteigerung weist der Speicher zwei Datenbussysteme auf, die jeweils mit der ersten und zweiten Kommunikationsschnittstelle verbunden sind und getrennt voneinander betreibbar sind. Hierdurch ist es insbesondere ermöglicht, gleichzeitig beide Kommunikationsschnittstellen aktiv zu betreiben. Erfolgt beispielsweise ein Speicherzugriff über die erste Kommunikationsschnittstelle über eines der Datenbussysteme, können vorteilhaft gleichzeitig über die zweite Kommunikationsschnittstelle empfangene Daten über das andere Datenbussystem in einen frei verfügbaren Speicherbereich des Speichers transferiert werden. Zu diesem Zweck werden die erste Kommunikationsschnittstelle und die zweite Kommunikationsschnittstelle des Speichers zur Datenübertragung parallel betrieben.

Zur Unterstützung einer derartigen Betriebsweise ist es außerdem vorteilhaft, daß jeweils ein frei verfügbarer Speicherbereich gleichzeitig in den unterteilten Speicherblöcken definiert wird, die unabhängig voneinander und parallel zum Einschreiben und Auslesen von Daten betrieben werden können. Durch diese Methodik ist sichergestellt, daß bei einem Speicherzugriff über die erste Kommunikationsschnittstelle auf einen der Speicherblöcke jeweils unabhängig davon ein frei verfügbarer Speicherbereich in dem anderen der Speicherblöcke verfügbar ist, der zeitgleich über die zweite Kommunikationsschnittstelle mit empfangenen Daten beschrieben werden kann.

Da bei der erfindungsgemäßen Speicheranordnung nur noch Punkt-zu-Punkt-Verbindungen auftreten, kann sie mit höchsten Frequenzen betrieben werden. Dabei scheinen bereits Übertragungsfrequenzen von bis zu 1 GHz erreichbar. Es sind dabei Speicher einsetzbar, deren Speicherzellenfelder in eine unterschiedliche Anzahl von Speicherbereichen, beispielsweise Speicherbänken, unterteilt sind, die jeweils getrennt voneinander aktivierbar sind.

In der erfindungsgemäßen Speicheranordnung können außerdem Speicher eingesetzt werden, die eine unterschiedliche Anzahl von Speicherzellen aufweisen und/oder in unterschiedlicher Herstellungstechnologie hergestellt sind. Das heißt, es sind unterschiedliche Speicher beziehungsweise Speicherbausteine miteinander kombinierbar. Es ist dabei vorteilhaft, für den ersten Speicher eine besonders schnelle Variante zur schnellen Kommunikation mit einem Mikrocontroller einzusetzen, die jedoch mit niedrigeren Datenübertragungsraten mit Speichern niedrigerer Frequenz und größerer Speicherzugriffszeit kommunizieren kann. Im Betrieb eines solchen Speichers weisen die erste und zweite Kommunikationsschnittstelle bei der Datenübertragung demgemäß unterschiedliche Operationsgeschwindigkeiten auf. Hierdurch wird insbesondere die sogenannte Latenzzeit für sofort erfolgreiche Speicherzugriffe auf den ersten Speicher verbessert. Die Gesamtkosten der Speicheranordnung steigen aber nur vergleichsweise moderat an, da der zweite Speicher und gegebenenfalls weitere Speicher niedrigeren Anforderungen entsprechen können. Werden Speicher verschiedener Größe in der gleichen Speicheranordnung eingesetzt, wird als erster Speicher beispielsweise ein besonders schneller Speicher gewählt, der jedoch eine vergleichsweise geringe Anzahl von Speicherzellen aufweist.

In einer weiteren Ausführungsform der Speicheranordnung sind die Speicher auf einem gemeinsamen Speichermodul zur Verwendung in einem Datenverarbeitungssystem aufgebracht. Die Speicheranordnung kann auch realisiert werden, indem die einzelnen Speicher direkt beispielsweise auf ein sogenanntes Motherboard eines PC-Systems aufgelötet werden.

Weitere vorteilhafte Aus- und Weiterbildungen sind in Unteransprüchen gekennzeichnet.

Die Erfindung wird im folgenden anhand der in der Zeichnung dargestellten Figuren, die Ausführungsbeispiele darstellen, näher erläutert. Es zeigen:
- Figur 1: eine schematische Darstellung bezüglich verschiedener Speicherzugriffe auf eine erfindungsgemäße Speicheranordnung,
- Figur 2: eine Ausführungsform eines erfindungsgemäßen Speichers,
- Figur 3: eine weitere Ausführungsform eines erfindungsgemäßen Speichers.

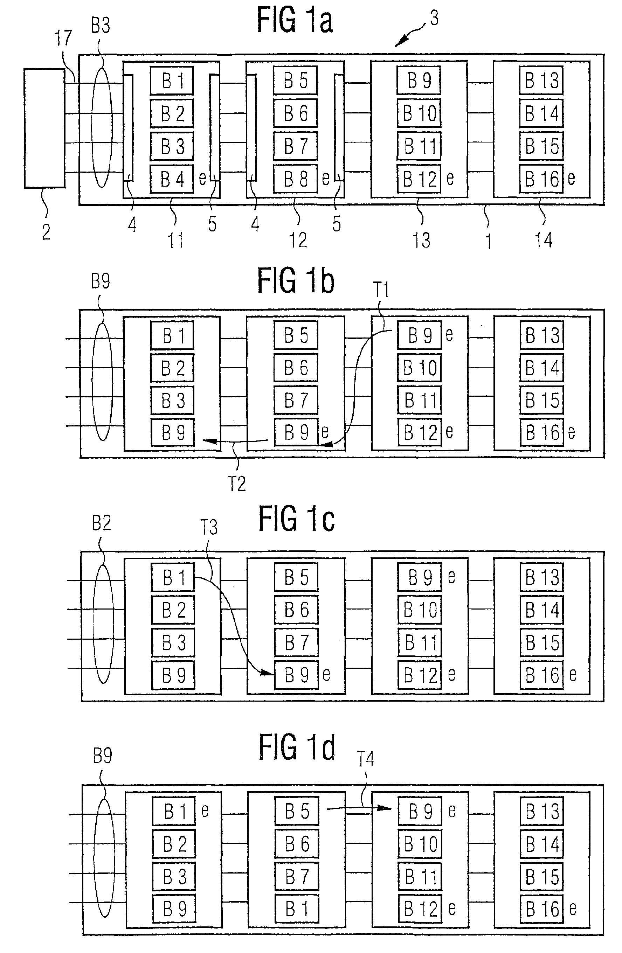

Figur 1 zeigt eine Speicheranordnung 3 mit einem Speichermodul 1, das einzelne Speicher beziehungsweise Speicherbausteine 11 bis 14 aufweist. Die Speicher 11 bis 14 weisen jeweils eine erste Kommunikationsschnittstelle 4 und eine zweite Kommunikationsschnittstelle 5 auf. Die erste Kommunikationsschnittstelle 4 des Speichers 11 ist mit einem Kommunikationsbus 17 verbunden, die zweite Kommunikationsschnittstelle 5 des Speichers 11 ist mit der ersten Kommunikationsschnittstelle 4 des Speichers 12 verbunden. Die Speicher 11 bis 14 sind jeweils in einzelne unabhängige Speicherbereiche beziehungsweise Speicherbänke B1 bis B16 unterteilt, die für einen Speicherzellenzugriff jeweils getrennt voneinander aktivierbar sind. Der Kommunikationsbus 17 ist mit einem Mikrocontroller 2 verbunden. In jedem der Speicher 11 bis 14 ist mindestens eine Speicherbank als frei verfügbare Speicherbank definiert. Das heißt, diese Speicherbank enthält keine für das betrachtete System relevanten Informationen, auf die zugegriffen werden könnte. Die frei verfügbaren Speicherbänke sind mit den Buchstaben e gekennzeichnet.

In den Teilabbildungen a bis d der Figur 1 sind insgesamt vier aufeinanderfolgende Speicherzugriffe zur Erläuterung der grundlegenden Funktionsweise der erfindungsgemäßen Speicheranordnung schematisch dargestellt. Ein vom Mikrocontroller 2 durchgeführter Speicherzugriff auf Daten einer der Speicherbänke wird dabei durch ein jeweiliges Kreissymbol am Kommunikationsbus 17 symbolisiert.

Das Teilbild a der Figur 1 zeigt beispielhaft einen Zugriff auf Daten, die in der Speicherbank B3 gespeichert sind. Da sich die gesuchten Daten im Speicher 11 befinden, werden diese an den Mikrocontroller 2 weitergegeben.

Im Teilbild b ist der Zugriff auf Daten aus der Speicherbank B9 dargestellt. Im Speicher 11 wird festgestellt, daß die gesuchten Daten dort nicht vorhanden sind. Deshalb wird vom Speicher 11 eine entsprechende Anforderung an Speicher 12 gesendet. Da die gesuchte Information dort ebenfalls nicht gefunden wird, sendet der Speicher 12 eine entsprechende Anforderung an den Speicher 13 und so weiter. Im Speicher 13 wird die gesuchte Information gefunden. Die gesuchten Daten der gesamten Speicherbank B9 werden in eine frei verfügbare Speicherbank B8 im Speicher 12 transferiert. Der Speicher 12 transferiert diese Daten wiederum weiter in eine frei verfügbare Speicherbank in Speicher 11. Mit den Daten der Speicherbank B9 ist nun die ursprünglich angeforderte Information auf dem Speicher 11 vorhanden und kann an den Mikrocontroller 2 weitergegeben werden. Der Datentransfer von Speicher 13 zum Speicher 11 ist mit den Datentransferrichtungen T1 und T2 symbolisiert. Zukünftige Speicherzugriffe in der Nähe des letzten Speicherzugriffs können nun schneller bearbeitet werden, da die Daten der Speicherbank B9 in die Nähe des Mikrocontrollers bewegt wurden.

Der Datentransfer von Speicherbank B9 kann ebenfalls in anderer Weise erfolgen. Es sind dabei Realisierungen denkbar, in denen direkt ein Datentransfer von Speicherbank B9 über den Speicher 12 zum Speicher 11 erfolgt, ohne die Daten der Speicherbank B9 zunächst im Speicher 12 zu speichern. Eine weitere Modifikation könnte darin bestehen, daß zunächst die vom Mikrocontroller 2 angefragten Daten aus der Speicherbank B9 über die Speicher 12 und 11 direkt an den Mikrocontroller 2 weitergeleitet werden, damit dieser sofort weiter arbeiten kann. Danach kann parallel zu anderen Mikrocontrollerzugriffen der Inhalt aus Speicherbank B9 bis zum Speicher 11 transferiert werden.

Zusammenfassend wird bei dem beschriebenen Betriebsverfahren also von außerhalb der Speicheranordnung 3 eine Adresse von angeforderten Daten an die erste Kommunikationsschnittstelle 4 des Speichers 11 angelegt. Im Speicher 11 wird festgestellt, ob die angelegte Adresse mit einer Adresse von im Speicher gespeicherten Daten übereinstimmt. Bei Übereinstimmung der Adressen werden die gespeicherten Daten über die Kommunikationsschnittstelle 4 ausgegeben. Bei Nicht-Übereinstimmung der Adressen wird die Adresse der angeforderten Daten an die zweite Kommunikationsschnittstelle transferiert, die angeforderten Daten werden über die Kommunikationsschnittstelle 5 des Speichers 11 empfangen und über die Kommunikationsschnittstelle 4 ausgegeben.

In Teilbild c ist die nunmehr neue Situation dargestellt. Die Daten der Speicherbank B9 wurden vom Speicher 11 bewegt, weshalb dieser keine frei verfügbare Speicherbank mehr aufweist. In diesem Moment erfolgt ein Speicherzugriff durch den Mikrocontroller auf Daten der Speicherbank B2. Weitere Datentransfers in den Speicher 11 sind nicht mehr möglich, da keine freie Speicherbank mehr verfügbar ist. Aus diesem Grund wird parallel zu laufenden Speicherzugriffen des Mikrocontrollers Information einer Speicherbank von Speicher 11 in Speicher 12 ausgelagert. Hierbei wird vorteilhaft eine Speicherbank gewählt, auf deren Daten bereits seit längerer Zeit kein Speicherzugriff mehr erfolgt ist. In diesem Fall werden die Daten der Speicherbank B1 in eine zuvor frei verfügbare Speicherbank von Speicher 12 transferiert (Datentransferrichtung T3).

In Teilbild d der Figur 1 ist nunmehr die neue entstandene Situation dargestellt. Die Speicherbank B1 kann wieder als frei verfügbare Speicherbank verwendet werden. Es erfolgt ein Speicherzugriff durch den Mikrocontroller auf Daten der Speicherbank B9. Da im Speicher 12 keine frei verfügbare Speicherbank mehr vorhanden ist, beginnt dieser parallel zum Speicherzugriff Daten einer seiner belegten Speicherbänke nach rechts zum Speicher 13 zu bewegen. Idealerweise wird hierfür diejenige Speicherbank ausgewählt, auf die am längsten nicht mehr zugegriffen wurde. In diesem Fall handelt es sich um Speicherbank B5 (Datentransferrichtung T4). Dieser Prozeß wird so lange fortgeführt, bis alle Speicher des Speichermoduls 1 zumindest eine frei verfügbare Speicherbank aufweisen. In dieser Ausführungsform wurde ein Verfahren gewählt, bei dem jeweils alle Daten einer betreffenden Speicherbank transferiert werden. Ebenso werden jeweils alle Daten einer Speicherbank des Speichers 12 vom Speicher 11 empfangen.

Die Speicher 11 bis 14 beziehungsweise deren Speicherzellenfelder können im Gegensatz zur Darstellung in Figur 1 in eine unterschiedliche Anzahl von Speicherbänken unterteilt werden. Ebenso ist es möglich, daß die Speicher 11 bis 14 jeweils eine unterschiedliche Anzahl von Speicherzellen aufweisen und/oder in unterschiedlicher Herstellungstechnologie hergestellt sind. Weisen beispielsweise der Speicher 11 und der Speicher 12 eine unterschiedliche Datenübertragungsfrequenz auf, so werden die Kommunikationsschnittstelle 4 und die Kommunikationsschnittstelle 5 des Speichers 11 bei der Datenübertragung mit unterschiedlichen Operationsgeschwindigkeiten betrieben.

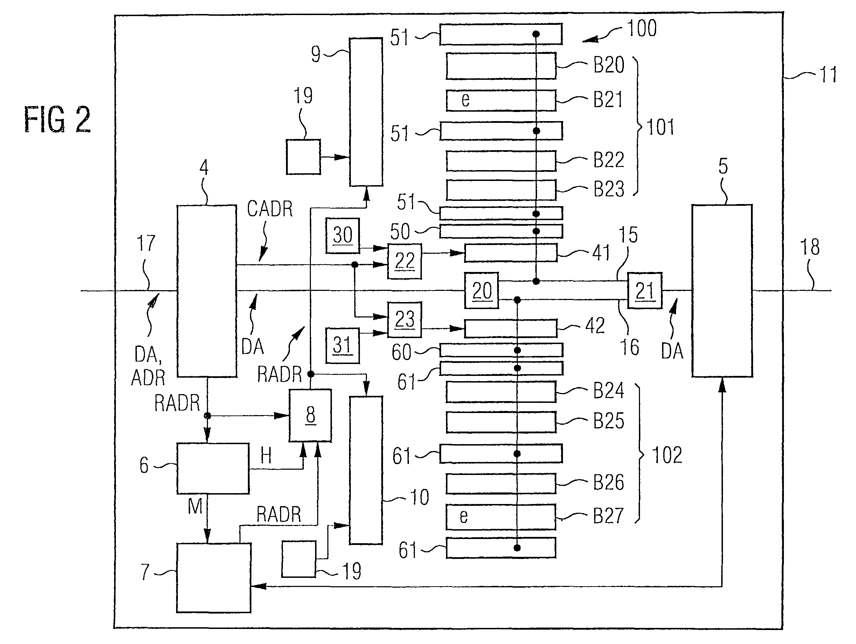

Figur 2 zeigt ein Ausführungsbeispiel eines erfindungsgemäßen integrierten Speichers, mit dem das beschriebene erfindungsgemäße Verfahren zum Betrieb einer Speicheranordnung durchführbar ist. Der Speicher 11 weist ein Speicherzellenfeld 100 zur Speicherung von Daten auf, das in Speicherblöcke 101 und 102 unterteilt ist, die jeweils unabhängig voneinander zum Einschreiben und Auslesen von Daten betrieben werden können. Jeder der Speicherblöcke 101 und 102 ist in Speicherbereiche beziehungsweise Speicherbänke B20 bis B23 und B24 bis B27 unterteilt. In jedem der Speicherblöcke 101 und 102 ist gleichzeitig jeweils eine frei verfügbare Speicherbank, gekennzeichnet durch den Buchstaben e, definiert. Zum Auslesen von Daten, die im Speicherzellenfeld 100 gespeichert sind, sind Leseverstärkerstreifen 51 beziehungsweise 61 und ein jeweiliger zweiter Leseverstärker 50 beziehungsweise 60 vorgesehen. Für einen Speicherzellenzugriff werden die Speicherblöcke jeweils durch Zeilendecoder 9 beziehungsweise 10 aktiviert. Zum Auslesen eines Datensignals DA aus dem Speicherzellenfeld 100 werden entsprechende Spaltendecoder 41 und 42 aktiviert.

Der Speicher 11 weist außerdem eine Kommunikationsschnittstelle 4 und eine Kommunikationsschnittstelle 5 auf. Diese sind jeweils unabhängig voneinander betreibbar und jeweils mit den Datenbussystemen 15 und 16 verbunden. Die Kommunikationsschnittstelle 4 ist mit dem Kommunikationsbus 17 verbunden, über den Datensignale DA und Adreßsignale ADR übertragen werden. Die Kommunikationsschnittstelle 5 ist mit einem Kommunikationsbus 18 verbunden.

Der Speicher 11 weist weiterhin eine Vergleichsschaltung 6 auf, die mit der Kommunikationsschnittstelle 4 verbunden ist und zum Vergleich einer Adresse von im Speicherzellenfeld 100 gespeicherten Daten mit einer an die Kommunikationsschnittstelle 4 angelegten Adresse RADR dient. Die Zeilenadresse RADR ist dabei ein Teil der Adresse ADR. Die Vergleichsschaltung 6 ist mit einer Kontrollschaltung 7 verbunden, die ihrerseits mit der Kommunikationsschnittstelle 5 verbunden ist und insbesondere zur Weiterleitung der Adresse der angeforderten Daten an die Kommunikationsschnittstelle 5 dient.

Durch das Vorsehen zweier Datenbussysteme 15 und 16 ist es möglich, gleichzeitig beide Kommunikationsschnittstellen 4 und 5 aktiv zu betreiben. Dadurch ist beispielsweise ein Speicherzugriff über die Kommunikationsschnittstelle 4 auf die Speicherbank B25 durchführbar, gleichzeitig ist ein Speicherzugriff über Kommunikationsschnittstelle 5 beispielsweise auf Speicherbank B21 durchführbar. Dies ist insbesondere vorteilhaft durchführbar, wenn das Laden von Daten einer Speicherbank über Kommunikationsschnittstelle 5 relativ lange dauert. Während dieser Zeit können ansonsten keine gesuchten Daten über die linke Kommunikationsschnittstelle 4 ausgegeben werden.

Um während des Ladens von Daten über Kommunikationsschnittstelle 5 gleichzeitig die gesuchte Information über Kommunikationsschnittstelle 4 weiterzuleiten, sind die Multiplexschaltungen 20 und 21 vorgesehen, die jeweils zwischen eine der Kommunikationsschnittstellen 4 und 5 und die Datenbussysteme 15 und 16 geschaltet sind.

Zum Zwecke einer einfachen Realisierung des Speichers ist ein Datenprotokoll vorgesehen, in welchem über die Kommunikationsschnittstelle 5 jeweils nur alle Daten einer kompletten Speicherbank transferiert beziehungsweise empfangen werden. Hierdurch ist es lediglich notwendig, eine Startadresse einmal zu übertragen und anschließend die Daten inkrementell zu empfangen beziehungsweise zu transferieren. Die notwendigen Datenadressen werden beispielsweise durch den sendenden Speicher oder empfangenden Speicher inkrementell erzeugt. Die entsprechende Adreßinformation für eine Datenübertragung über die Kommunikationsschnittstelle 5 wird von einer Zählerschaltung 30 beziehungsweise 31 bereitgestellt. Diese sind jeweils mit einer Multiplexschaltung 22 beziehungsweise 23 verbunden, die an einem zweiten Eingang jeweils mit einem Adreßbus zur Übertragung der Spaltenadresse CADR verbunden sind. Die Ausgänge der Multiplexschaltungen 22 und 23 sind mit den jeweiligen Spaltendecodern 41 und 42 verbunden.

In der Vergleichsschaltung 6 wird festgehalten, welche der Speicherbänke B20 bis B27 gerade welche Adreßbereiche der Anwendungsinformation beinhaltet. Erfolgt beispielsweise über Kommunikationsschnittstelle 4 ein Zugriff auf eine bestimmte Speicheradresse, so erfolgt in der Vergleichsschaltung 6 ein Vergleich, ob die Speicheradresse in einer der Speicherbänke B20 bis B27 verfügbar ist. Erst danach kann die entsprechende physikalische Zeilenadresse identifiziert und aktiviert werden. Ist dies nicht der Fall, so wird ein Signal M generiert, welches die Kontrollschaltung 7 aktiviert. Die Kontrollschaltung 7 fordert anschließend die Daten der entsprechenden Speicherbank mit der gewünschten Information über Kommunikationsschnittstelle 5 an und veranlaßt das Laden der Daten dieser Speicherbank in eine der frei verfügbaren Speicherbänke des Speicherzellenfeldes 100.

Die Zeilensteuerungsschaltung 8 hat die Aufgabe, mögliche Konflikte für die Zeilenadresse RADR aufzulösen. Diese können beispielsweise bei gleichzeitigem Zugriff durch Kommunikationsschnittstelle 4 und 5 entstehen. Greift zum Beispiel Kommunikationsschnittstelle 4 auf Daten in Speicherbank B25 zu, so wird das Signal H aktiviert, da die gesuchten Daten im Speicher 11 vorhanden sind. Entsprechend muß die physikalische Zeilenadresse der Bank B25 aktiviert werden, d.h. gleichzeitig kann keine neue Zeileninformation über Kommunikationsschnittstelle 5 übertragen werden.

Der Speicher 11 weist außerdem programmierbare Elemente 19 auf, durch die eine der Speicherbänke des Speichers für einen Datenzugriff gesperrt werden können. In den programmierbaren Elementen 19 wird dazu die Adresse einer zu deaktivierenden Speicherbank gespeichert. Die programmierbaren Elemente 19 sind beispielsweise mittels einer elektrischen Spannung oder durch einen von außen zugeführten Laserstrahl programmierbar.

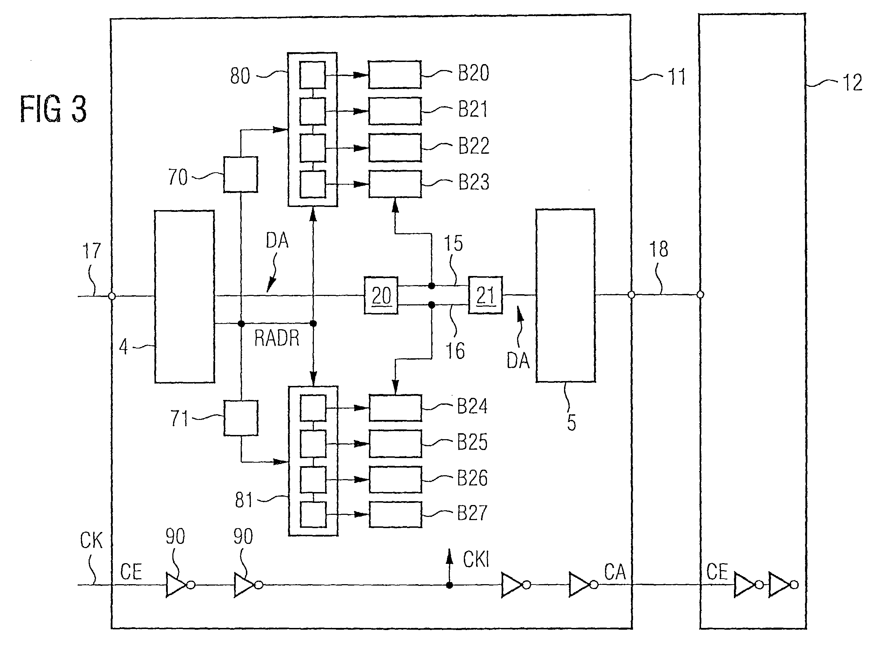

In Figur 3 ist eine weitere Ausführungsform eines erfindungsgemäßen Speichers dargestellt. Der Speicher 11 ist über Kommunikationsschnittstelle 5 mit dem Speicher 12 verbunden. Zum Betrieb dieser Speicheranordnung weist diese ein Taktsignal CK auf, das mit einem Takteingang CE des Speichers 11 verbunden ist. Ein Taktausgang CA des Speichers 11 ist mit einem Takteingang CE des Speichers 12 verbunden. Zur Übertragung des Taktsignals CK können vorteilhaft einfache Treiberschaltungen 90 vorgesehen werden. Aus dem Taktsignal CK wird ein internes Taktsignal CKI zur Steuerung des Betriebs des Speichers 11 erzeugt.

Für herkömmliche Speichersysteme wird meist ein globaler Takt zur Verfügung gestellt, der zu allen Systemkomponenten über relativ weite Strecken verteilt werden muß. Da die beschriebene Speicheranordnung jedoch nur auf lokale Punkt-zu-Punkt-Kommunikationen basiert, ist eine feste Zeitreferenz nur jeweils zwischen zwei verbundenen Speichern notwendig. Deshalb ist es ausreichend, eine Zeitreferenz in Form eines Taktsignals jeweils über kurze Strecken nur zwischen zwei kommunizierenden Speicher vorzusehen. Neben der einfachen Realisierung ist dadurch gewährleistet, daß eine exakte Zeitreferenz zur Kommunikation zwischen zwei Speichern bereitgestellt ist.

Der Speicher 11 gemäß Figur 3 weist mehrere Register 70, 71 und 80, 81 jeweils zur Speicherung eines unterschiedlichen Teils einer Adresse von im Speicher 11 gespeicherten Daten auf. In diesen Registern wird die Zeilenadresse des aktuellen Speicherzugriffs mit Speicheradressen von Daten verglichen, die gerade in den Speicherbänken des Speichers abgespeichert sind. Dadurch wird festgestellt, ob die gewünschte Information verfügbar und in welcher Speicherbank diese abgespeichert ist. Erst danach kann die entsprechende physikalische Zeilenadresse identifiziert und aktiviert werden.

Je größer der benötigte Speicherplatz zum Vergleich der Adressen ist, desto langsamer ist der Vergleich und somit der Speicherzugriff. Aus diesem Grund ist es vorteilhaft, daß die Register jeweils unabhängig voneinander mit der Kommunikationsschnittstelle 4 verbunden sind, um einen Vergleich der jeweiligen Teiladressen mit der an die Kommunikationsschnittstelle 4 angelegten Adresse durchzuführen. Dadurch erhält man ein hierarchisches und verteilt aufgebautes Zeilen-Cache-System. Dieses wird in die Registergruppen 70, 71 und 80, 81 unterteilt. Die Register 70, 71 entscheiden zum Beispiel anhand eines Teiles der Zeilenadressen, ob sich die gesuchten Daten in der oberen Hälfte des Speicherzellenfeldes oder in der unteren Hälfte des Speicherzellenfeldes befinden. Parallel dazu werden die verbleibenden Zeilenadressen parallel den Registern 80 und 81 zugeführt. Diese entscheiden, welche der jeweiligen 4 Speicherbänke aktiviert werden. Durch die parallele Verarbeitung wird hier die Geschwindigkeit gesteigert. Dabei sind auch andere Aufteilungen beziehungsweise serielle Verfahren zum Vergleich der Zeilenadressen denkbar.

### Bezugszeichenliste

- 1: Speichermodul
- 2: Mikrocontroller
- 3: Speicheranordnung
- 4, 5: Kommunikationsschnittstelle
- 6: Vergleichsschaltung
- 7: Kontrollschaltung
- 8: Zeilensteuerungsschaltung
- 9, 10: Zeilendecoder
- 11 bis 14: Speicher
- 15, 16: Datenbussystem
- 17, 18: Kommunikationsbus
- 19: programmierbare Elemente
- 20, 21: Multiplexschaltung
- 22, 23: Multiplexschaltung
- 30, 31: Zählerschaltung
- 41, 42: Spaltendecoder
- 50, 60: zweiter Leseverstärker
- 51, 61: Leseverstärkerstreifen
- 70, 71: Register
- 80, 81: Register
- 90: Treiber
- 100: Speicherzellenfeld
- 101, 102: Speicherblock
- B20 bis B27: Speicherbereich
- B1 bis B16: Speicherbereich
- T1 bis T4: Datentransferrichtung
- DA: Daten
- RADR: Zeilenadresse
- CADR: Spaltenadresse
- ADR: Adresse
- CK: Taktsignal
- CKI: internes Taktsignal
- CE: Takteingang
- CA: Taktausgang
- e: frei verfügbarer Speicherbereich

## Patentansprüche

1. Integrierter Speicher
- mit einem Speicherzellenfeld (100) zur Speicherung von Daten sowie mit einer ersten und zweiten Kommunikationsschnittstelle (4, 5) zur Datenübertragung, die jeweils unabhängig voneinander betreibbar sind,
- bei dem die erste und zweite Kommunikationsschnittstelle (4, 5) jeweils mit einem Datenbussystem (15, 16) verbunden sind,
- bei dem das Speicherzellenfeld (100) für einen Speicherzellenzugriff mit dem Datenbussystem (15, 16) verbindbar ist,
- mit einer Vergleichsschaltung (6), die mit der ersten Kommunikationsschnittstelle (4) verbindbar ist, zum Vergleich einer Adresse (RADR) von im Speicherzellenfeld gespeicherten Daten (DA) mit einer an die erste Kommunikationsschnittstelle (4) angelegten Adresse (ADR) und zur Aktivierung des Speicherzellenfeldes (100) für einen Speicherzellenzugriff in Abhängigkeit eines Vergleichsergebnisses,
- mit einer Kontrollschaltung (7), die mit der Vergleichsschaltung (6) und der zweiten Kommunikationsschnittstelle (5) verbindbar ist, zur Weiterleitung der angelegten Adresse (ADR) an die zweite Kommunikationsschnittstelle (5) in Abhängigkeit des Vergleichsergebnisses der Vergleichsschaltung (6).

2. Integrierter Speicher nach Anspruch 1,
**dadurch gekennzeichnet, daß**
das Speicherzellenfeld (100) in mehrere Speicherbereiche (B20 bis B27) unterteilt ist, die jeweils getrennt voneinander aktivierbar sind.

3. Integrierter Speicher nach Anspruch 2,
**dadurch gekennzeichnet, daß**
einer der Speicherbereiche (B20 bis B27) deaktivierbar ist und der Speicher programmierbare Elemente (19) zur Speicherung einer Adresse des deaktivierbaren Speicherbereichs aufweist.

4. Integrierter Speicher nach einem der Ansprüche 1 bis 3,
**dadurch gekennzeichnet, daß**
der Speicher eine Zählerschaltung (30, 31) aufweist zur Bereitstellung von Adreßinformation für eine Datenübertragung über die zweite Kommunikationsschnittstelle (5).

5. Integrierter Speicher nach einem der Ansprüche 1 bis 4,
**dadurch gekennzeichnet, daß**
das Speicherzellenfeld (100) in zwei Speicherblöcke (101, 102) aufgeteilt ist, die unabhängig voneinander mit dem Datenbussystem (15, 16) verbindbar sind.

6. Integrierter Speicher nach einem der Ansprüche 1 bis 5,
**dadurch gekennzeichnet, daß**
der Speicher zwei Datenbussysteme (15, 16) aufweist, die jeweils mit der ersten und zweiten Kommunikationsschnittstelle (4, 5) verbunden sind und getrennt voneinander betreibbar sind.

7. Integrierter Speicher nach Anspruch 6,
**dadurch gekennzeichnet, daß**
der Speicher eine Multiplexschaltung (20, 21) aufweist, die zwischen eine der Kommunikationsschnittstellen (4, 5) und die Datenbussysteme (15, 16) geschaltet ist.

8. Integrierter Speicher nach einem der Ansprüche 1 bis 7,
**dadurch gekennzeichnet, daß**
der Speicher mehrere Register (70, 71, 80, 81) aufweist, in denen jeweils ein unterschiedlicher Teil einer Adresse von gespeicherten Daten gespeichert ist.

9. Integrierter Speicher nach Anspruch 8,
**dadurch gekennzeichnet, daß**
die Register (70, 71, 80, 81) jeweils unabhängig voneinander mit der ersten Kommunikationsschnittstelle (4) verbindbar sind zum Vergleich der jeweiligen Teiladressen mit der an die erste Kommunikationsschnittstelle angelegten Adresse.

10. Speicheranordnung mit wenigstens einem ersten Speicher und zweiten Speicher jeweils nach einem der Ansprüche 1 bis 9,
**dadurch gekennzeichnet, daß**
die erste Kommunikationsschnittstelle (4) des ersten Speichers (11) mit einem Kommunikationsbus (17) und die zweite Kommunikationsschnittstelle (5) des ersten Speichers (11) mit der ersten Kommunikationsschnittstelle (4) des zweiten Speichers (12) verbunden ist.

11. Speicheranordnung nach Anspruch 10,
**dadurch gekennzeichnet, daß**
die Speicherzellenfelder der Speicher (11 bis 14) in eine unterschiedliche Anzahl von Speicherbereichen (B1 bis B16) unterteilt sind, die jeweils getrennt voneinander aktivierbar sind.

12. Speicheranordnung nach einem der Ansprüche 10 bis 11,
**dadurch gekennzeichnet, daß**
die Speicher (11 bis 14) eine unterschiedliche Anzahl von Speicherzellen aufweisen und/oder in unterschiedlicher Herstellungstechnologie hergestellt sind.

13. Speicheranordnung nach einem der Ansprüche 10 bis 12,
**dadurch gekennzeichnet, daß**
die Speicher (11 bis 14) auf einem gemeinsamen Speichermodul (1) zur Verwendung in einem Datenverarbeitungssystem aufgebracht sind.

14. Speicheranordnung nach einem der Ansprüche 10 bis 13,
**dadurch gekennzeichnet, daß**
die erste und zweite Kommunikationsschnittstelle (4, 5) des ersten Speichers (11) bei der Datenübertragung unterschiedliche Operationsgeschwindigkeiten aufweisen.

15. Speicheranordnung nach einem der Ansprüche 10 bis 14,
**dadurch gekennzeichnet, daß**
ein Anschluß für ein Taktsignal (CK) der Speicheranordnung mit einem Takteingang (CE) des ersten Speichers (11) verbunden ist und ein Taktausgang (CA) des ersten Speichers (11) mit einem Takteingang (CE) des zweiten Speichers (12) verbunden ist.

16. Verfahren zum Betrieb einer Speicheranordnung mit wenigstens einem ersten Speicher (11) zur Speicherung von Daten, der eine erste und zweite Kommunikationsschnittstelle (4, 5) zur Datenübertragung aufweist, und einem zweiten Speicher (12) zur Speicherung von Daten mit einer ersten und zweiten Kommunikationsschnittstelle (4, 5) zur Datenübertragung, dessen erste Kommunikationsschnittstelle (4) mit der zweiten Kommunikationsschnittstelle (5) des ersten Speichers (11) verbunden ist,
- bei dem die erste und zweite Kommunikationsschnittstelle (4, 5) jeweils des ersten und zweiten Speichers (11, 12) unabhängig voneinander betrieben werden,
- bei dem von außerhalb der Speicheranordnung (3) eine Adresse (ADR) von angeforderten Daten (DA) an die erste Kommunikationsschnittstelle (4) des ersten Speichers (11) angelegt wird,
- bei dem in dem ersten Speicher (11) festgestellt wird, ob die angelegte Adresse (ADR) mit einer Adresse (RADR) von im ersten Speicher gespeicherten Daten übereinstimmt,
- bei dem bei Übereinstimmung der Adressen die gespeicherten Daten (DA) über die erste Kommunikationsschnittstelle (4) des ersten Speichers (11) ausgegeben werden,
- bei dem bei Nicht-Übereinstimmung der Adressen die Adresse (ADR) der angeforderten Daten an die zweite Kommunikationsschnittstelle (5) des ersten Speichers (11) transferiert wird, die angeforderten Daten (DA) von der ersten Kommunikationsschnittstelle (4) des zweiten Speichers (12) über die zweite Kommunikationsschnittstelle (5) des ersten Speichers (11) empfangen werden und über die erste Kommunikationsschnittstelle (4) des ersten Speichers (11) ausgegeben werden.

17. Verfahren nach Anspruch 16,
**dadurch gekennzeichnet, daß**
die über die zweite Kommunikationsschnittstelle (5) des ersten Speichers (11) empfangenen Daten im ersten Speicher (11) gespeichert werden.

18. Verfahren nach Anspruch 17,
**dadurch gekennzeichnet, daß**
die empfangenen Daten nach Ausgabe über dessen erste Kommunikationsschnittstelle (4) im ersten Speicher (11) gespeichert werden.

19. Verfahren nach Anspruch 17 oder 18,
**dadurch gekennzeichnet, daß**
im ersten Speicher (11) ein frei verfügbarer Speicherbereich (e) zur Speicherung von Daten definiert wird, der zur Speicherung von empfangenen Daten verwendet wird.

20. Verfahren nach Anspruch 19,
**dadurch gekennzeichnet, daß**
in dem frei verfügbaren Speicherbereich (e) vor der Speicherung von empfangenen Daten keine anforderbaren Daten gespeichert sind.

21. Verfahren nach Anspruch 19 oder 20,
**dadurch gekennzeichnet, daß**
- der erste Speicher (11) in Speicherbereiche (B1 bis B4) zur Speicherung von Daten unterteilt wird,
- Daten eines der Speicherbereiche (B1) in den zweiten Speicher (12) transferiert werden und der eine der Speicherbereiche (B1) als frei verfügbarer Speicherbereich (e) definiert wird.

22. Verfahren nach Anspruch 21,
**dadurch gekennzeichnet, daß**
die Daten des einen der Speicherbereiche (B1) transferiert werden, wenn kein frei verfügbarer Speicherbereich (e) im ersten Speicher (11) vorhanden ist.

23. Verfahren nach Anspruch 21 oder 22,
**dadurch gekennzeichnet, daß**
alle Daten des einen der Speicherbereiche (B1) transferiert werden.

24. Verfahren nach einem der Ansprüche 19 bis 23,
**dadurch gekennzeichnet, daß**
- der erste Speicher (11) in Speicherblöcke (101, 102) zur Speicherung von Daten unterteilt wird, die unabhängig voneinander zum Einschreiben und Auslesen von Daten (DA) betrieben werden,
- in den Speicherblöcken (101, 102) gleichzeitig jeweils ein frei verfügbarer Speicherbereich (e) definiert wird.

25. Verfahren nach einem der Ansprüche 16 bis 24,
**dadurch gekennzeichnet, daß**
der zweite Speicher (12) in Speicherbereiche (B5 bis B8) zur Speicherung von Daten unterteilt wird und jeweils alle Daten eines der Speicherbereiche (B5 bis B8) des zweiten Speichers (12) über die zweite Kommunikationsschnittstelle (5) des ersten Speichers (11) empfangen werden.

26. Verfahren nach einem der Ansprüche 16 bis 25,
**dadurch gekennzeichnet, daß**
- der erste Speicher (11) und/oder zweite Speicher (12) in Speicherbereiche (B20 bis B27) zur Speicherung von Daten unterteilt wird,
- einer der Speicherbereiche (B20 bis B27) des ersten Speichers (11) und/oder des zweiten Speichers (12) für einen Datenzugriff gesperrt wird.

27. Verfahren nach einem der Ansprüche 16 bis 26,
**dadurch gekennzeichnet, daß**
die erste Kommunikationsschnittstelle (4) und zweite Kommunikationsschnittstelle (5) eines der Speicher (11, 12) zur Datenübertragung parallel betrieben werden.
